# EUROPEAN PATENT APPLICATION

(11) **EP 4 552 913 A1**
(43) Date of publication of application: **14.05.2025**
(21) Application number: 24212569.8
(22) Date of filing: 13.11.2024
(51) Int. Cl.: B60L 53/62, B60L 7/10, B60L 58/15

(54) **DETERMINATION OF TARGET STATE OF CHARGE BASED ON ESTIMATED GRADIENT AND CONFIDENCE FACTOR**

(30) Priority: 13.11.2023 US 202363598416 P
(71) Applicant: Paccar Inc, Bellevue, WA 98004 (US)
(72) Inventor: KHUNTIA, Satvik, Bellingham (US); HERTLEIN, Nicholas Lee, Bellingham (US); MEIJER, Maarten, Anacortes (US); NELSON, James, Bellingham (US)
(74) Representative: Calysta NV

(57) **Abstract**

A battery control component of an electric vehicle may limit charging of a battery on the electric vehicle to a target state of charge (SOC), such as to reserve battery capacity for regenerative braking during downgrades. A computing device associated with the vehicle may calculate an estimated gradient profile and/or an estimated total energy consumption of a predicted upcoming route of the vehicle based on one or more data items, such as GPS data, altitude data, and/or map data. The computing device may determine a target SOC based on the estimated gradient profile. The computing device may determine a confidence factor associated with the estimated gradient profile, where the confidence factor depends on the quantity of data items used to calculate the estimated gradient profile. The computing device may adjust the target SOC based on the confidence factor.

## Description

### CROSS REFERENCE TO RELATED APPLICATION

This application claims priority to U.S. Patent Application No. 63/598,416, filed on November 13, 2023, the entire content of which is incorporated herein by reference.

### FIELD

One or more aspects of embodiments according to the present disclosure relate to determining a target state of charge (SOC) of an electric vehicle battery based on an estimated upcoming gradient profile and, in some cases, adjusting the target state of charge based on a confidence factor associated with the estimation.

### BACKGROUND

Electric and hybrid vehicles use regenerative brakes to capture kinetic energy expended during braking and convert it into electricity that can be stored in a battery on the vehicle. Regenerative brakes slow the vehicle down (and capture the kinetic energy) by reversing the vehicle's electric motor. Regenerative brakes can serve as an additional source of braking capacity for the vehicle, but only when the battery is not full or the regenerative brakes are coupled with another device to dissipate captured kinetic energy, such as a brake resistor. Brake resistors, however, add weight and cost to a vehicle and may be disfavored. In the absence of a brake resistor or similar energy dissipation mechanism, the SOC of the battery may determine how much additional braking capacity is available.

The above information disclosed in this Background section is only for enhancement of understanding of the background of the present disclosure, and therefore, it may contain information that does not form prior art.

### SUMMARY

According to an example implementation, a method is described, the method including: determining a value of a radius r representing a distance at which a vehicle is estimated to have consumed a predetermined quantity of energy; determining whether there are one or more descents that satisfy a criterion and begin within a circle having the radius r and centered at a location of the vehicle; in accordance with a determination that there are one or more descents that satisfy the criterion and begin within the circle: identifying one or more possible paths that each start at the location of the vehicle and include a descent of the one or more descents, identifying a worst-case predicted total energy consumption for the one or more possible paths, determining a target state of charge (SOC) based on the worst-case predicted total energy consumption, determining a confidence value for the determined target SOC, determining an adjusted target SOC based on the determined target SOC and the confidence value, and causing a battery of the vehicle to be charged to the adjusted target SOC.

In some examples, the value of the radius r is determined based at least in part on an energy consumption characteristic of the vehicle, an altitude of the vehicle, or both.

In some examples, determining whether there are one or more descents that satisfy the criterion and begin within the circle includes calculating one or more altitude changes between one or more pairs of topographic nodes, where each topographic node represents a geographic location and an altitude.

In some examples, the method further includes: obtaining a set of topographic nodes including the one or more pairs of topographic nodes; and selecting the one or more pairs of topographic nodes from the set of topographic nodes based at least in part on a location of the vehicle.

In some examples, determining whether there are one or more descents that satisfy the criterion and begin within the circle includes estimating one or more gradient profiles based on a location of the vehicle, an altitude of the vehicle, a road map, or a combination of these.

In some examples, the criterion is satisfied when a grade of at least a portion of a descent exceeds a first threshold grade, when the distance of the descent exceeds a first threshold distance, when an average grade over a second threshold distance exceeds a second threshold grade, or a combination of these.

In some examples, identifying the one or more possible paths that each start at the location of the vehicle and include a descent of the one or more descents includes identifying one or more sets of topographic nodes including a starting node that is closest to the location of the vehicle and one or more ending nodes corresponding to the end of the one or more descents.

In some examples, identifying the worst-case predicted total energy consumption for the one or more possible paths includes predicting an energy consumption for each possible path of the one or more possible paths by: identifying one or more sets of topographic nodes corresponding to the one or more possible paths; calculating altitude changes between pairs of topographic nodes of each set of topographic nodes; and estimating a total energy consumption for each set of topographic nodes based on the calculated altitude changes and on energy consumption characteristics of the vehicle.

In some examples, identifying the worst-case predicted total energy consumption for the one or more possible paths includes: predicting the total energy consumption for each possible path of the one or more possible paths based on topographic mapping data; and selecting a lowest predicted total energy consumption as the worst-case predicted total energy consumption.

In some examples, in accordance with a determination that there are no descents that satisfy the criterion and begin within the circle, causing the battery of the vehicle to be charged to a maximum SOC.

According to an example implementation, a computing device for a vehicle is described, the computing device including: at least one processor; and a memory, operatively connected to the at least one processor and storing instructions that, when executed individually or collectively by the at least one processor cause the computing device to perform a method, the method including: determining a value of a radius r representing a distance at which a vehicle is estimated to have consumed a predetermined quantity of energy; determining whether there are one or more descents that satisfy a criterion and begin within a circle having the radius r and centered at a location of the vehicle; in accordance with a determination that there are one or more descents that satisfy the criterion and begin within the circle: identifying one or more possible paths that each start at the location of the vehicle and include a descent of the one or more descents, identifying a worst-case predicted total energy consumption for the one or more possible paths, determining a target state of charge (SOC) based on the worst-case predicted total energy consumption, and causing a battery of the vehicle to be charged to the target SOC.

In some examples, the value of the radius r is determined based at least in part on an energy consumption characteristic of the vehicle, an altitude of the vehicle, or both.

In some examples, determining whether there are one or more descents that satisfy the criterion and begin within the circle includes calculating one or more altitude changes between one or more pairs of topographic nodes, where each topographic node includes a geographic location and an altitude.

In some examples, the method further includes: obtaining a set of topographic nodes including the one or more pairs of topographic nodes; and selecting the one or more pairs of topographic nodes from the set of topographic nodes based at least in part on a location of the vehicle.

In some examples, determining whether there are one or more descents that satisfy the criterion and begin within the circle includes estimating one or more gradient profiles based on a location of the vehicle, an altitude of the vehicle, a road map, or a combination of these.

In some examples, the criterion is satisfied when a grade of at least a portion of the descent exceeds a first threshold grade, when the distance of the descent exceeds a first threshold distance, when the average grade over a second threshold distance exceeds a second threshold grade, or a combination of these.

In some examples, identifying the one or more possible paths that each start at the location of the vehicle and include a descent of the one or more descents includes identifying one or more sets of topographic nodes including a starting node that is closest to the location of the vehicle and one or more ending nodes corresponding to the end of the one or more descents.

In some examples, identifying the worst-case predicted total energy consumption for the one or more possible paths includes predicting the energy consumption for each possible path of the one or more possible paths by:identifying one or more sets of topographic nodes corresponding to the one or more possible paths; calculating altitude changes between pairs of topographic nodes of each set of topographic nodes; and estimating the total energy consumption for each set of topographic nodes based on the corresponding altitude changes and on energy consumption characteristics of the vehicle.

In some examples, the method further includes: in accordance with a determination that there are no descents that satisfy the criterion and begin within the circle, causing the battery of the vehicle to be charged to a maximum SOC.

According to an example implementation, a method is described, the method including: obtaining one or more data items, including a vehicle location of an electric vehicle; calculating, based on the one or more data items, an estimated gradient profile between the vehicle location and a second location; determining a target state of charge for a battery of the vehicle based on the estimated gradient profile; determining a confidence factor based on the one or more data items; and adjusting the target state of charge based on the confidence factor to generate an adjusted target state of charge.

### BRIEF DESCRIPTION OF THE DRAWINGS

Non-limiting and non-exhaustive examples of the present embodiments are described with reference to the following figures, wherein like reference numerals refer to like parts throughout the various views unless otherwise specified.
FIG. 1 depicts concepts related to determining a target state of charge based on an estimated gradient, according to some examples;
FIG. 2 depicts an example of a topographic node grid, according to some examples;
FIG. 3 depicts concepts related to determining a target state of charge based on an estimated gradient, according to some examples;
FIG. 4 depicts concepts related to determining a target state of charge based on an estimated gradient, according to some examples;
FIG. 5 depicts a method for determining a target state of charge based on an estimated gradient, according to some examples;
FIG. 6 depicts a method for determining a target state of charge based on an estimated gradient, according to some examples; and
FIG. 7 is a block diagram of a computing device that may be used for adjusting a target state of charge based on an estimated gradient and a confidence factor according to some examples.

### DETAILED DESCRIPTION

Hereinafter, examples will be described in more detail with reference to the accompanying drawings, in which like reference numbers refer to like elements throughout. The present disclosure, however, may be embodied in various different forms, and should not be construed as being limited to only the illustrated examples herein. Rather, these examples are provided so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof may not be repeated. Further, in the drawings, the relative sizes of elements, layers, and regions may be exaggerated and/or simplified for clarity.

Electric and hybrid vehicles can use regenerative brakes to augment the braking capacity of their mechanical (friction-based) braking systems. Regenerative braking may be particularly useful for electric heavy-duty vehicles because such vehicles are susceptible to overheating during long descents but do not include gas engines and therefore cannot use engine braking ("Jake brakes") to augment their service brakes, as has been the traditional approach to maintaining heavy-duty vehicle braking safety. However, in vehicles that lack a brake resistor (or other means to dissipate extra energy generated by a regenerative braking motor), regenerative braking is only available when the battery of the regenerative braking system is not full. In this case, if a vehicle begins a descent with a full battery, the vehicle cannot use regenerative braking during the descent and must rely on mechanical brakes.

In some cases, it is desirable to allocate a certain percentage of the battery as headroom that can be used to enable regenerative braking during upcoming descents. For example, when the vehicle's battery is connected to a charging station, a controller or other computing device on the vehicle may stop the charging before the battery reaches its full capacity in order to maintain battery capacity for storing regenerative braking energy during descents. Instead of fully charging the battery, the battery may be charged to a predetermined maximum charging threshold, such as 80% of the battery capacity. In some examples, the predetermined charging threshold is a value that is defined in safety regulations associated with the vehicle and is determined based on the braking capacity needed to maintain the speed of the vehicle below a specified value when the vehicle descends a grade of a specified distance and gradient (e.g., 30km/h for 6 km at 7% grade). The predetermined charging threshold may be determined based on a worst-case descent scenario to ensure that there is sufficient battery headroom. Depending on the gradient profile (e.g., the elevation changes) of the vehicle's upcoming route, however, the predetermined charging threshold may be too conservative, resulting in wasted battery capacity and reduced range of the vehicle before needing another charge. For example, if the upcoming route is fairly flat, the vehicle may not need as much battery headroom as if the upcoming route has significant descents. Similarly, if the upcoming route has a flat or uphill portion before an upcoming descent such that part of the battery capacity is depleted before the beginning of the descent, the vehicle may not need as much battery headroom as if the upcoming route has a descent immediately after the battery of the vehicle is charged. Thus, it may be desirable to modify the target SOC based on the gradient profile of the upcoming route. It will be appreciated that although examples of the present application are discussed with respect to "a battery," a vehicle may have multiple batteries or battery packs, and the term "battery" is intended to encompass multiple batteries and battery packs that may be powering a vehicle.

In some cases, the upcoming route of the vehicle is known, and the gradient profile can be determined with high accuracy based on the known upcoming route. In this case, the target SOC may be adjusted based on the determined gradient profile (e.g., rather than using the same predetermined charging threshold regardless of route). For example, a computing device (such as the vehicle control unit) can predict the amount of electricity that will be drained from the battery during flat and uphill (and/or gradual downhill) portions of the upcoming route and predict the amount of electricity that will be stored in the battery during significant downhill portions of the upcoming route and adjust the target SOC to ensure that the battery has sufficient capacity to support regenerative braking during the downhill portions.

In some cases, however, the upcoming route is not known and therefore the actual gradient profile cannot be easily or specifically determined. As described herein, in some examples, a gradient profile can be estimated in the absence of a known route based on the current location of the vehicle and the topography of the area around the vehicle. For example, candidate routes and corresponding gradient profiles can be identified based on a current location (e.g., a longitude and latitude) of the vehicle, based on an altitude (e.g., an elevation) of the vehicle and/or other topographic information, and/or based on road maps that can be used to identify multiple potential routes that the vehicle may take

As described herein, in some cases, the gradient profile (and/or corresponding energy consumption of the vehicle) is estimated using a set of topographic nodes representing location and altitude information. The set of topographic nodes may be pre-generated and accessible to a computing device of the vehicle. Each topographic node may include a latitude, longitude, and altitude. The topographic nodes may be used to estimate energy consumption of a vehicle along node paths (e.g., paths traversing a grid of topographic nodes) by determining altitude differences between nodes along the path and using vehicle energy consumption characteristics to estimate the amount of energy consumed or generated based on the altitude differences. A computing device on the vehicle may determine, using the topographic nodes, whether there are any significant descents that begin within a particular radius of the current location of the vehicle (e.g., at the charging station), where the radius may represent a distance from the vehicle at which the vehicle is predicted to have consumed a predetermined quantity of energy (e.g., in terms of a percentage of the vehicle's battery, such as 20%, or in terms of an absolute quantity of energy, such as a value having units of ampere-hours or kilowatt-hours). The radius may be determined based on historic or predicted energy consumption characteristics of the vehicle and/or on other factors that may affect the vehicle's energy consumption. The radius may represent an estimated distance at which the vehicle is likely to have depleted its battery to a state in which regenerative braking can be supported for a significant descent. In examples, a descent may be considered significant if it is likely to require the use of regenerative braking due to its grade, distance, or a combination of these. For example, some descents may be ignored because they are gradual enough that, should braking be needed, friction brakes of the vehicle are sufficient to safely slow or stop the vehicle. The computing device may determine whether there are any significant descents that begin within the circle by determining altitude changes between adjacent pairs of topographic nodes (e.g., by traversing a set of nodes) as a proxy for using a known route, or may identify a possible route using road map data and approximate the altitude changes along the route using a set of topographic nodes that correspond to the route (e.g., nodes having locations along or near the route).

If the computing device determines that there are no significant descents that begin within the circle, the computing device may set the target SOC to a maximum value, such as to 100% (or substantially 100%) of the battery capacity. If the computing device determines that there are one or more significant descents that begin within the radius, the computing device uses the nodes to identify the worst-case path through the nodes that the vehicle may take (in terms of the amount of battery headroom needed for the descent relative to the amount of charge consumed by the vehicle prior to reaching the start of the descent) and adjusts the target SOC to accommodate the worst-case path (e.g., the worst-case estimated gradient profile).

In some examples, the accuracy of an estimated gradient profile depends on which and/or how many data items are available for use in predicting the route and/or estimating the gradient profile. The more information is available, the more accurate the route prediction (and therefore gradient estimation) can be. For example, if only the location of the vehicle is known (e.g., altitude data and road data are not available), the gradient profile can be estimated with relatively low confidence. If the altitude of the vehicle is known or can be estimated using topographic information such as topographic nodes or other topographic data, the gradient profile can be estimated with greater confidence. If road data (e.g., a street map) is also available (e.g., in addition to the GPS location and the altitude), the gradient profile can be estimated with greater confidence because the potential paths can be narrowed to those that correspond to possible road routes. If topographic nodes are available to the computing device, the computing device may estimate the altitude of the vehicle using the altitude of the topographic node that is closest to the vehicle, and/or may evaluate all possible node paths (e.g., determine the gradient profile over each node path) within the determined radius to determine the gradient profiles with greater accuracy. In some cases, the accuracy of the estimated gradient profiles depends on the resolution of the topographic nodes (e.g., how closely the topographic nodes are spaced).

Thus, in some examples, a computing device calculates an estimated gradient profile using one or more data items (e.g., location, altitude data, and/or road data) and determines a target SOC based on the worst-case estimated gradient profile. In some examples, the computing device adjusts the target SOC based on a confidence factor associated with the one or more data items, such as by multiplying the target SOC by the confidence factor to calculate an adjusted target SOC.

In some examples, the target SOC is expressed as a percentage of a capacity of the battery, and the confidence factor is expressed as a numeric value ranging from 0 to 1, with 0 indicating no confidence in the estimated gradient profile (e.g., the estimated gradient profile is not at all likely to be accurate) and 1 indicating absolute confidence in the estimated gradient profile (e.g., the estimated gradient profile is determined based on a known upcoming route). For example, an estimated gradient profile that is calculated using only a GPS location of the vehicle may have a corresponding confidence factor of .8. An estimated gradient profile that is calculated using GPS information and current altitude information for the vehicle may have a corresponding confidence factor of .85. An estimated gradient profile that is calculated using a GPS location, altitude information, and road information may have a confidence factor of .9. Such values are intended to illustrate the concept of the confidence factor; other values can be used without departing from the scope of the disclosure.

Additional details regarding systems and methods for adjustment of target state of charge based on estimated gradient and confidence factor are described with reference to the drawings.

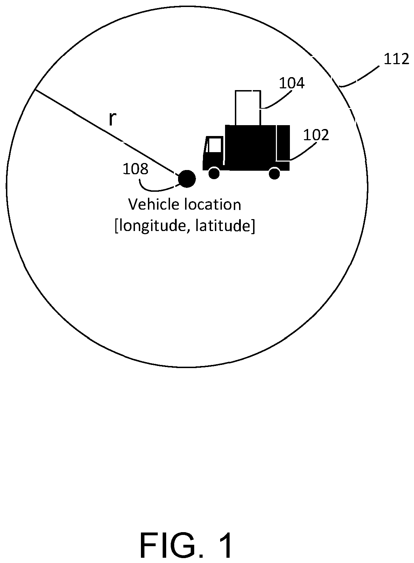

FIG. 1 illustrates concepts related to adjusting a target SOC based on an estimated gradient according to some examples. In the example of FIG. 1, an electric vehicle 102 is charging a battery of the electric vehicle 102 at a stationary charging station 104. In some examples, the electric vehicle 102 is a heavy-duty truck, such as a Class 8 truck. For instance, the vehicle 102 may include a cab compartment and a sleeper compartment attached to the cab. It will be appreciated that aspects of the disclosed subject matter may have wide application and, therefore, may be suitable for use with any type of vehicle, such as passenger vehicles, motorcycles, buses, light, medium, and heavy-duty vehicles, trains, boats, yachts, motor homes, etc. Moreover, the methods and systems described herein can be used by vehicles that use various drivetrains, including electrified vehicles and hybrid vehicles. As used herein, electric vehicle 102 may include a hybrid vehicle. Accordingly, the following descriptions and illustrations herein should be considered illustrative in nature and, thus, do not limit the scope of the claimed subject matter.

In some examples, the electric vehicle 102 includes a charging controller (e.g., a computing device) that controls the SOC at which the charging station 104 ceases to charge the battery. In some examples, the target SOC (e.g., the SOC at which the charging station 104 ceases to charge the battery) is determined by a separate computing device, such as a vehicle control unit located on the electric vehicle 102 or a remote computing device, and the computing device provides the target SOC to the charging controller of the electric vehicle 102 and/or to the charging station 104 to cause the charging station 104 to cease charging the battery when it reaches the target SOC.

In some examples, the computing device obtains the vehicle location 108 from a sensor (e.g., a GPS sensor) located on the electric vehicle 102. In some examples, the computing device obtains the vehicle location 108 from the charging station 104. For example, the GPS location of the charging station 104 may be retrieved by the computing device from the charging station 104 or from a remote computing device that stores the location of the charging station 104 and used as a proxy for the vehicle location 108.

In some examples, the computing device determines, based on the current location, topographic information, and/or mapping data, multiple candidate routes that the vehicle may traverse from its current location. In some examples, the computing device determines, based on the current location, topographic information, and/or mapping data, whether there are any significant descents within a particular radius r of the location of the vehicle. The radius r defines a circle 112 within which the computing device will search for the start of one or more significant descents.

The computing device may determine (e.g., select, calculate) the value of r based at least in part on historic energy consumption information associated with the vehicle (e.g., energy consumption for the vehicle itself or for other vehicles of similar makes and models), based on the vehicle's mass and/or current load, and/or based on other factors that may affect the vehicle's energy consumption. Such information may be stored at the vehicle or otherwise accessible to the vehicle. In some examples, the value of r may be determined based at least in part on the current actual or estimated altitude of the vehicle. For example, if the computing device determines that the vehicle is at a high altitude (e.g., based on known altitude information of the vehicle or charging station, or estimated using one or more nearby topographic nodes), the vehicle is more likely to encounter a significant descent within a smaller radius than when the vehicle is at a low altitude. Thus, the computing device may determine a smaller r when the vehicle is at a high altitude than when the vehicle is at a low altitude. In some examples, r is determined based on one or more vehicle-specific parameters such as weight, power rating, regenerative braking limits, or other vehicle characteristics that affect energy consumption of the electric vehicle 102.

In the example of FIG. 1, the radius r of circle 112 around the electric vehicle 102 represents a conservative estimate of a distance (radius) the electric vehicle 102 would drive to expend sufficient energy that the vehicle battery has enough headroom to support regenerative braking for a significant descent, such as a distance at which the vehicle is predicted to have consumed a predetermined quantity of energy. Once the computing device has determined r, the computing device predict one or more gradient profiles representing paths that the electric vehicle 102 may take from its initial location to locations along and/or up to the perimeter of the circle. For example, the computing device may predict the gradient profiles based on the current location of the vehicle, topographic mapping data for the area within the circle, and/or road map data that includes possible road routes that may be traversed by the electric vehicle 102.

In some examples, when the computing device estimates the gradient profile based on the vehicle location 108 in the absence of detailed nearby altitude data and road data, the computing device assigns a first value to a confidence factor based on using only the vehicle location 108 (e.g., without using altitude data or road data). In some examples, the computing device adjusts (e.g., decreases) the target SOC based on the value of the confidence factor (e.g., if the confidence value is expressed as a value between zero and one, by multiplying the target SOC by the confidence factor) to provide additional battery headroom in consideration of having limited information with which to estimate the gradient profile. In some examples, if the adjusted target SOC is less than the predetermined charging threshold, the computing device sets the adjusted target SOC to the predetermined charging threshold (e.g., the predetermined charging threshold is used as a minimum target SOC).

In some examples, in addition to having access to the vehicle location 108, the computing device has access to altitude data associated with the vehicle location 108. For example, the computing device has access to altitude data stored on the electric vehicle 102 or has access to an application or service that enables the computing device to retrieve (e.g., based on the vehicle location 108) altitude data (e.g., topographic nodes or other topographic information) for an area around the vehicle location 108. In this case, the computing device estimates the gradient profile based on the vehicle location 108 and the altitude data, such as by determining an average altitude change between the vehicle location 108 and one or more locations at a radius r from the vehicle location 108, such as to determine whether there are likely to be any significant descents before the battery reaches the predetermined charging threshold.

In some examples, when the computing device estimates the gradient profile based on the vehicle location 108 and altitude data (without using road data), the computing device assigns a second value to the confidence factor based on using a combination of the vehicle location 108 and the altitude data. In some examples, the second value is higher than the first value (e.g., the value of the confidence factor when only the vehicle location 108 is available). In some examples, the computing device adjusts the target SOC based on the second value of the confidence factor as previously described.

In some examples, in addition to having access to the vehicle location 108 and the altitude data, the computing device has access to road information for roads that are within a threshold distance of vehicle location 108, such as a map that includes road information. For example, the computing device has access to map data stored on the electric vehicle 102 or has access to an application or service that enables the computing device to retrieve (e.g., based on the vehicle location 108) road data for an area around the vehicle location 108, such as within some or all of the area of circle 112. In this case, the computing device identifies one or more candidate routes that the electric vehicle 102 may traverse after it leaves the charging station 104. In some examples, the computing device identifies candidate routes based on a constraint associated with the electric vehicle 102. For example, if the electric vehicle is a heavy-duty vehicle, the computing device may identify routes on which heavy-duty vehicles are legally able to travel and/or routes that are preferred by operators of heavy-duty vehicles. In some examples, the computing device estimates the gradient profile of each of the candidate routes and determines a worst-case gradient profile, then determines the target SOC based on the worst-case gradient profile.

In some examples, when the computing device estimates the gradient profile based on the vehicle location 108, altitude data, and road data, the computing device assigns a third value to the confidence factor based on using a combination of the vehicle location 108, altitude data, and road data. The third value may be greater than the second value. In some examples, the computing device adjusts the target SOC based on the third value of the confidence factor as previously described.

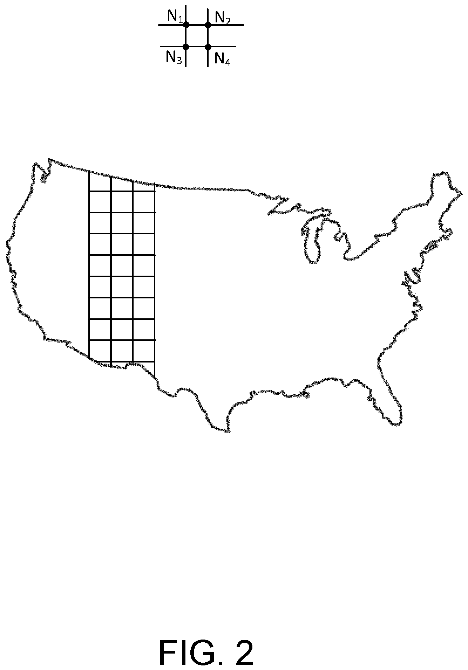

Additionally or alternatively, the computing device may predict gradient profiles using a set of topographic nodes. For example, the computing device may have access to a set of topographic nodes Nₓ, such as shown in FIG. 2, that each includes a GPS location and an altitude. Each node may lie at an intersection of a topographic node grid that is overlaid on a geographic area to roughly characterize the topography of that area. The set of nodes may be pre-generated based on more detailed topographic mapping data and may form a grid that characterizes altitudes of geographic locations. In some cases, the grid is uniformly spaced across a relatively large geographic area, such as shown in FIG. 2. In other cases, the grid is non-uniformly spaced such that regions having more topographic variability (e.g., mountainous regions) have a greater density of nodes than regions having less topographic variability (e.g., flat regions). The set of nodes (and corresponding location and altitude data) may be stored on the vehicle or remotely accessible to the vehicle, such as via a cloud connection or via a data connection to the charging station. For example, the vehicle may obtain, from local or remote storage, a set of topographic nodes associated with a geographic area around the vehicle based on a current location of the vehicle. In some examples, the vehicle may store a coarse version of the map of topographic nodes that can be used in a worst-case scenario where it is unable to communicate either with the charging station or with a cloud-based storage system to obtain more detailed topographic nodes. In some examples, if only the coarse version of the node map is available for determining gradient profiles representing paths that the vehicle 102 may take, the confidence value may be decreased, e.g., proportionately.

In some examples, the computing device determines whether there are any significant descents that begin within the circle of radius r by traversing paths through the node grid (e.g., the set of nodes) from an initial node (e.g., a node closest to the electric vehicle 102 or charging station 104) to multiple final nodes (e.g., nodes at or beyond the radius r) and computing altitude differences between each pair of nodes in a path to identify significant descents.

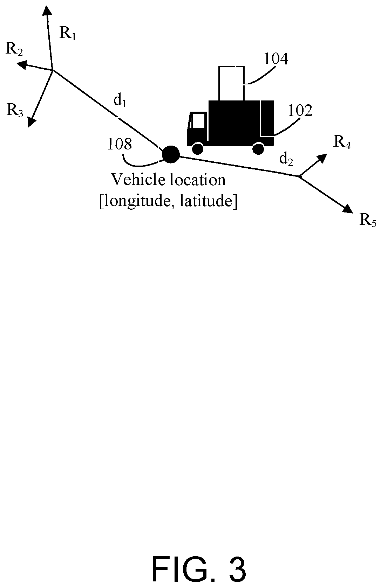

If the computing device determines that there is a significant descent that begins within the circle of radius r, the computing device identifies one or more potential paths downhill from the start of the descent to the end of the descent, each path having a distance R from the beginning of the descent to the node having the lowest altitude along the path. For example, FIG. 3 illustrates a scenario in which the computing device identifies two significant descents that begin within the circle of radius r-one that begins at a distance d1 from the current location of the vehicle and one that begins at a distance d2. From the start of the descents, there are multiple paths that can be taken to go downhill. From d1, the vehicle may take a first downhill path having a first distance R1, a second downhill path having a second distance R2, or a third downhill path having a third distance R3. Similarly, from d2, the vehicle may take a first downhill path having a fourth distance R4 or a second downhill path having a fifth distance R5. The computing device determines, using the topographic nodes, the predicted total energy consumption for each of the possible paths. The computing device determines the altitude changes along these paths by accumulating altitude changes between pairs of nodes along the path, then predicts the total energy consumption (including energy regained via regenerative braking) along each path as a function of, for example, the gradient profile of the path (including the grade of the descent), historic energy consumption information for the vehicle, the vehicle's mass, and/or other factors that may affect the vehicle's energy consumption. As used herein, energy consumption can either be considered both positive (energy used by the vehicle's drivetrain or other systems to operate the vehicle) or negative (energy regained by regenerative braking). In examples, a vehicle may include a rating that includes the maximum percentage of potential energy that can be recaptured by a regenerative braking system, which will affect the calculation of predicted total energy consumption for that vehicle. In some examples, the computing device determines the predicted total energy consumption by the electric vehicle 102 along each path as the sum of energies between each pair of topographic nodes along the path. The computing device then determines an SOC buffer based on the worst-case total energy consumed, by setting the buffer value to the absolute value of the worst-case total energy consumed when the value is less than 0 (e.g., when more energy is gained during the descent than consumed beforehand) and setting the buffer to 0 when the value is greater than or equal to 0 (e.g., no battery headroom is required). The target SOC is then determined as the maximum SOC - buffer.

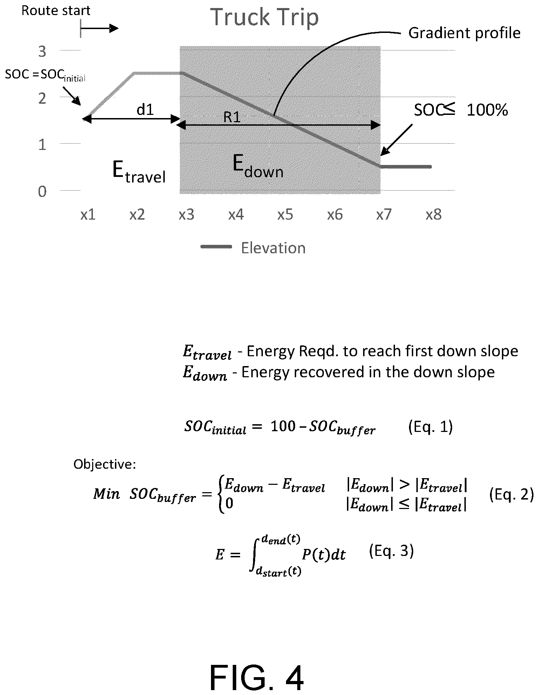

FIG. 4 depicts an example of determining a target SOC based on predicted energy consumption, such as for a known or estimated gradient profile. In the example of FIG. 4, an electric vehicle (e.g., a truck) is initially located at x1 (e.g., at a charging station). One possible route that the electric vehicle may traverse is a route from x1 to x8, where the route has a gradient profile as shown with a significant descent starting at x3. The distance d1 represents the distance before the downgrade is encountered, with Eₜᵣₐᵥₑₗ representing the predicted total energy consumed (e.g., provided by the battery) before the downgrade and E_{down} representing the predicted energy recovered (e.g., stored in the battery) during the downgrade. The optimization goal is to set the target (initial) SOC to a value that provides sufficient headroom for braking during the descent (e.g., sufficient headroom to accommodate E_{down}). SOCᵢₙᵢₜᵢₐₗ, representing the target SOC, can be determined based on Eq. 1, where SOC_{buffer} represents the amount of battery capacity reserved for regenerative braking. The minimum value of SOC_{buffer} is determined based on Eq. 2, with the energy values determined based on Eq. 3, which integrates power to determine total energy, in nonexclusive examples.

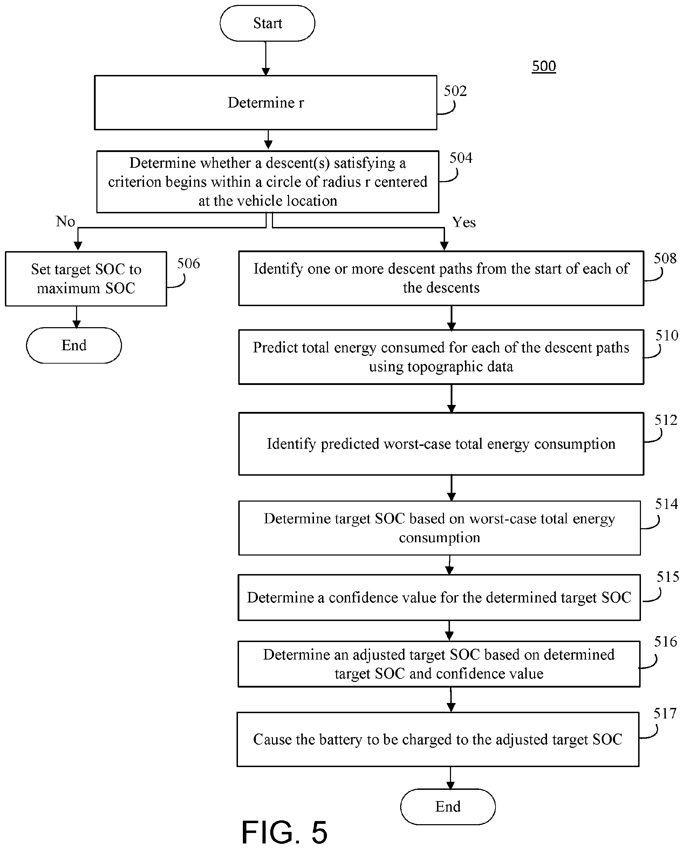

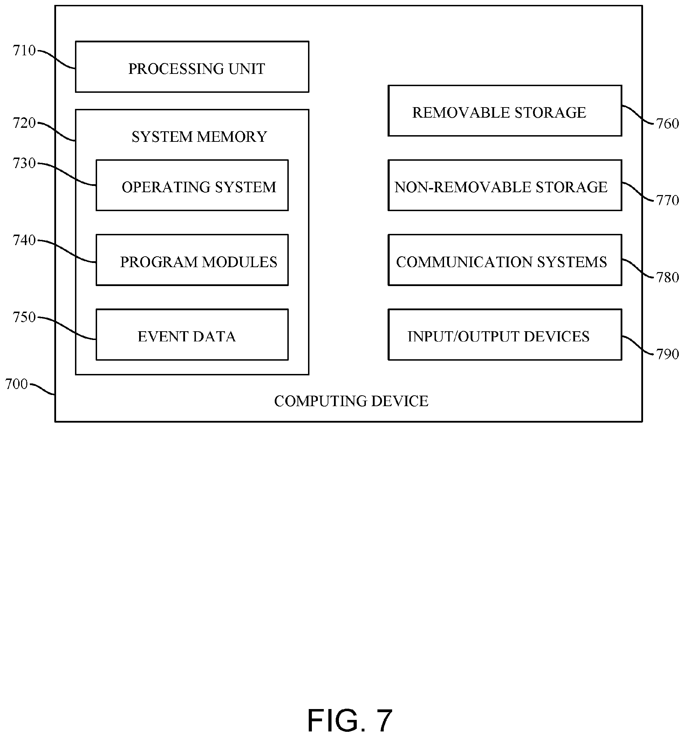

FIG. 5 depicts a flow diagram of a process for adjusting a target SOC. In some examples, some or all of the operations of the process 500 may be performed by a computing device of a vehicle, such as computing device 700 of FIG. 7. It should be understood that the sequence of operations of the process is not fixed, but can be modified, changed in order, performed differently, performed sequentially, concurrently, or simultaneously, or altered into any desired sequence, as recognized by a person of skill in the art. In some examples, certain operations depicted in the process 500 may be omitted, and in certain examples, other operations may be added.

At operation 502, the computing device determines a value of r (e.g., a radius of a circle centered at a location of the vehicle, as shown in FIG. 1). For example, the computing device may determine a value of r by estimating, based on the vehicle energy consumption characteristics, a distance at which the battery of the vehicle will be sufficiently depleted to provide enough headroom for a significant descent. The computing device may determine r based on the vehicle's historic energy usage, a mass of the vehicle, or other vehicle characteristics that may affect the vehicle's energy consumption. Additionally or alternatively, the computing device may determine r based on an altitude of the vehicle or an altitude of a charging station at which the vehicle is located. For example, if the vehicle is at a high altitude, the computing device may reduce the value of r since the vehicle is likely to begin a significant descent within a relatively short distance. The computing device may determine the altitude based on the location of the vehicle and topographic data, such as a topographic map and/or a set of topographic nodes (e.g., by using the altitude of the topographic node that is closest to the location of the vehicle or charging station).

At operation 504, the computing device determines whether there are any descents that satisfy a criterion and that begin within a circle of radius r centered at the vehicle's location. In some examples, the criterion is satisfied when the grade of the descent exceeds a threshold, when the distance of the descent exceeds a threshold, and/or when the average grade over a predetermined distance exceeds a threshold. For example, the criterion may be satisfied when the grade meets or exceeds an average of 7% for a distance that meets or exceeds 6km, although other criteria are possible and contemplated. Each of these conditions may increase the likelihood that the vehicle will need to use regenerative braking during the descent. The computing device may determine whether there are any descents that satisfy the criterion by computing altitude changes between pairs of adjacent topographic nodes for multiple node paths that start at a topographic node that is closest to the vehicle and end at a topographic node that may be at or near the perimeter of the circle (e.g., a distance r from the vehicle).

In accordance with a determination at 504 that there are no descents that satisfy the criterion within the circle of radius r, at 506 the computing device sets the target SOC for the vehicle to a maximum SOC, which may be at or near an SOC representing 100% battery charge.

In accordance with a determination at 504 that there is at least one descent that satisfies the criterion and begins within the circle of radius r, at 508 the computing device identifies one or more possible descent paths from the start of the descent to the lowest altitude of the descent. For example, the computing device may use topographic nodes to identify possible descent paths by identifying topographic node paths starting from the node at which the descent begins to nodes at which the altitude is the lowest for that descent path (e.g., nodes for which adjacent nodes have higher altitudes). In other examples, the computing device identifies the possible descent paths based on road map data and/or based on topographic maps.

At 510, the computing device predicts the total energy that would be consumed by the vehicle (including energy gained during regenerative braking) for each of the possible paths using topographic data, such as topographic nodes or a topographic map. For example, the computing device may predict the total energy that would be consumed for a possible path starting from a topographic node closest to the location of the vehicle to a node at which the altitude is the lowest. The computing device may predict the total energy consumption based on the altitude changes along each node path along with information related to the vehicle's energy consumption, such as historic energy consumption information, mass of the vehicle, or other types of information. If the computing device identifies possible descent paths based on road map data, the computing device may associate each possible path with a corresponding set of topographic nodes that are closest to the possible path, thereby approximating the altitude changes of the paths.

At 512, the computing device identifies the worst-case (e.g., lowest) predicted total energy consumption. The worst-case total energy consumption may be a negative number if more energy is predicted to be gained during the descent than is predicted to be consumed during the portion of the path before the descent (e.g., |E_{down}| > |Eₜᵣₐᵥₑₗ|, in FIG. 4), or may be a positive number if more energy is predicted to be consumed than is predicted to be gained during the descent (e.g., |E_{down}| < |Eₜᵣₐᵥₑₗ|).

At 514, the computing device determines a target SOC based on the worst-case predicted total energy consumption. For example, if the worst-case predicted total energy consumption is a positive value (more energy is predicted to be consumed than regained), the computing device may set the target SOC to a maximum SOC, such as to an SOC representing at or near 100% battery capacity. If the worst-case predicted total energy consumption is a negative value (more energy is predicted to be regained than consumed), the computing device may set the target SOC to the maximum SOC minus an SOC buffer, where the SOC buffer is equal to the absolute value of the worst-case predicted energy consumption, such as shown in FIG. 4. For example, the SOC buffer may be equal to the predicted energy regained during the descent (E_{down}) minus the predicted energy consumed from the starting location to the start of the descent (Eₜᵣₐᵥₑₗ).

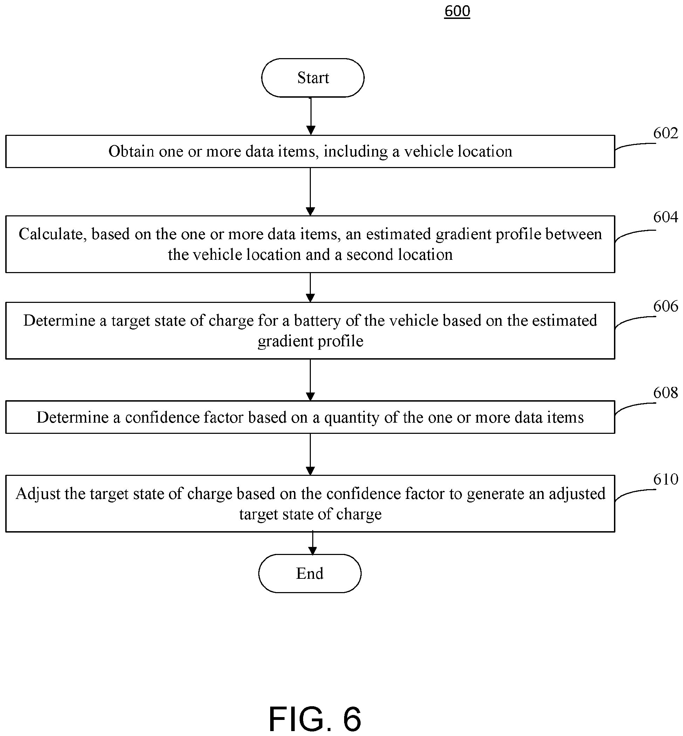

At operation 515, a confidence value for the determined target SOC is determined, e.g., in the manner described above and with respect to FIG. 6 hereafter. At operation 516, an adjusted target SOC is determined based on the determined target SOC from operation 514 and the confidence value determined at operation 515. For example, as described, the adjusted target SOC may be calculated as a product of the confidence value and the determined target SOC.

At 517, the computing device causes the battery to be charged to the target SOC, such as by sending a signal to a charging controller or to the charging station indicating the target SOC and/or by sending a signal to the charging controller or to the charging station to cease charging when the SOC reaches the target SOC.

FIG. 6 depicts a flow diagram of a process 600 for adjusting a target SOC based on an estimated gradient and a confidence factor according to one example. In some examples, some or all of the operations of the process 600 may be performed by a computing device, such as computing device 700. It should be understood that the sequence of operations of the process is not fixed, but can be modified, changed in order, performed differently, performed sequentially, concurrently, or simultaneously, or altered into any desired sequence, as recognized by a person of skill in the art. In some examples, certain operations depicted in the process 600 may be omitted, and in certain examples, other operations may be added.

At operation 602, a computing device obtains one or more data items associated with an electric vehicle, including a vehicle location (e.g., vehicle location 108 of FIG. 1). In some examples, the vehicle location is a GPS location including a latitude and a longitude. In some examples, the computing device obtains the vehicle location of the vehicle using a sensor (e.g., a GPS sensor) on the vehicle. In some examples, the computing device obtains the GPS location of the vehicle based on information received from a second computing device, such as from a charging station with which the vehicle is connected (e.g., while charging a battery of the vehicle) or a remote server.

In some examples, the one or more data items includes altitude data associated with the vehicle location, such as altitude data representing surface altitudes between (and including) the vehicle location and a destination location and/or between the vehicle location and a threshold distance from the vehicle location (e.g., the radius r in FIG. 1). In some examples, the computing device obtains the altitude data based on an electronic altitude map, such as topographic mapping data, or as a set of topographic nodes. In some examples, the computing device obtains the altitude data from a memory device on the electric vehicle and/or obtains the altitude data from a charging station.

In some examples, the one or more data items include road data associated with the vehicle location, such as road data representing roads between the vehicle location and a destination location and/or between the vehicle location and a radius from the vehicle location (e.g., the radius r in FIG. 1). In some examples, the computing device obtains the road data based on electronic mapping data. In some examples, the computing device obtains the road map data from a memory device on the electric vehicle or from a charging station. In some examples, the computing device obtains the road map data from a remote computing device over a wireless connection.

At operation 604, the computing device calculates an estimated gradient profile between the vehicle location and a second location based on the one or more data items obtained at operation 602. In some examples, the computing device calculates the estimated gradient profile by estimating, based on the vehicle location, a threshold distance (e.g., a distance of a radius r) at which the electric vehicle will reach a predetermined charging threshold and determining whether the electric vehicle is likely to encounter a significant descent before reaching the threshold distance. In some examples, the computing device calculates the estimated gradient profile based on the vehicle location and altitude data by estimating an average altitude change between the vehicle location and a destination location (if there is a known destination location) or between the vehicle location and the threshold distance (e.g., the radius r). In some examples, the computing device calculates the estimated gradient profile based on the vehicle location, altitude data, and road data, such as by identifying one or more candidate routes between the vehicle location and a destination location or between the vehicle location and the threshold distance, and calculating an estimated gradient profile for each of the candidate routes. In some examples, the computing device selects a worst-case gradient profile for the candidate routes as the estimated gradient profile.

At operation 606, the computing device determines a target SOC for a battery of the vehicle based on the estimated gradient profile, such as based on Eq. 1 and Eq. 2 in FIG. 2, where E_{down} and Eₜᵣₐᵥₑₗ are calculated based on the estimated gradient profile.

At operation 608, the computing device determines a confidence factor based on the one or more data items. In some examples, the computing device determines the confidence factor based on a quantity of the one or more data items. For example, if the gradient profile is estimated based on a single data item that includes vehicle location (e.g., in the absence of altitude data, road data, and a known route), the computing device selects a first confidence factor. For example, if the gradient profile is estimated based on two data items that include vehicle location and altitude data (e.g., in the absence of road data and a known route), the computing device selects a second confidence factor, where the second confidence factor is larger than the first confidence factor. For example, if the gradient profile is estimated based on three data items including vehicle location, altitude data, and road data (e.g., in the absence of a known route), the computing device selects a third confidence factor greater than the second confidence factor.

Additionally or alternatively, in some examples, the computing device determines the confidence factor based on a quality of the one or more data items, such as based on the accuracy, recency, granularity, resolution, or other quality-related (e.g., qualitative) aspect of the data items. For example, the computing device may determine a quality of map altitude data based on the granularity of the map altitude data, based on a proximity of the map altitude data to the current location of the electric vehicle, and/or based on other factors. In some examples, based on a determination that the quality of the one or more data items corresponds to a first quality, the computing device may select a first confidence value. In some examples, based on a determination that the quality of the one or more data items corresponds to a second quality that is lower than the first quality, the computing device may select a second confidence value that is lower than the first confidence factor.

At operation 610, the computing device adjusts the target SOC determined at operation 606 based on the confidence factor determined at operation 608 to generate an adjusted target SOC, such as by multiplying the target SOC by the confidence factor to generate the adjusted target SOC. In some examples, the adjusted target SOC is used to control an amount of charging of a battery on the electric vehicle. For example, the computing device may cause the battery to be charged to the adjusted target SOC, such as by sending a signal to the charging station indicating the adjusted target SOC and/or by sending a signal to the charging station to cease charging when the SOC reaches the adjusted target SOC.

FIG. 7 is a block diagram of a computing device 700 according to an example. The computing device 700, or various components and system of the computing device 700, may be an example of a computing device described with reference to FIGs. 1-6. In examples, the computing device 700 comprises a vehicle control unit of a vehicle, such as electric vehicle 102. As shown in FIG. 7, the physical components (e.g., hardware) of the computing device 700 are illustrated and these physical components may be used to practice the various aspects of the present disclosure.

The computing device 700 may include at least one processing unit 710 (e.g., a processor and/or other type of processing circuitry) and a system memory 720. The system memory 720 may include, but is not limited to, volatile storage (e.g., random access memory), non-volatile storage (e.g., read-only memory), flash memory, or any combination of such memories. The system memory 720 may also include an operating system 730 that controls the operation of the computing device 700 and one or more program modules 740. The program modules 740 may be responsible for adjusting a target SOC based on an estimated gradient according to the various examples of the present disclosure. A number of different program modules and data files may be stored in the system memory 720. While executing on the processing unit 710, the program modules 740 may perform the various processes described above.

The computing device 700 may also have additional features or functionality. For example, the computing device 700 may include additional data storage devices (e.g., removable and/or non-removable storage devices) such as, for example, magnetic disks, optical disks, or tape. These additional storage devices are labeled as a removable storage 760 and a non-removable storage 770.

Examples of the disclosure may also be practiced in an electrical circuit comprising discrete electronic elements, packaged or integrated electronic chips containing logic gates, a circuit utilizing a microprocessor, or on a single chip containing electronic elements or microprocessors. For example, examples of the disclosure may be practiced via a system-on-a-chip where each or many of the components illustrated in FIG. 7 may be integrated onto a single integrated circuit. Such a system-on-a-chip device may include one or more processing units, graphics units, communications units, system virtualization units and various application functionality all of which are integrated (or "burned") onto the chip substrate as a single integrated circuit.

When operating via a system-on-a-chip, the functionality, described herein, may be operated via application-specific logic integrated with other components of the computing device 700 on the single integrated circuit (chip). The disclosure may also be practiced using other technologies capable of performing logical operations such as, for example, AND, OR, and NOT, including but not limited to mechanical, optical, fluidic, and quantum technologies.

The computing device 700 may include one or more communication systems 780 that enable the computing device 700 to communicate with other electronic devices such as, for example, servers, routers, network devices, other computing devices, etc. Examples of communication systems 780 include, but are not limited to, wireless communications systems, wired communications systems, cellular communications systems, radio frequency (RF) transmitter, receiver, and/or transceiver circuitry, a Controller Area Network (CAN) bus, a universal serial bus (USB), parallel, serial ports, etc.

The computing device 700 may also have one or more input devices and/or one or more output devices shown as input/output devices 790. These input/output devices 790 may include a keyboard, a sound or voice input device, haptic devices, a touch, force and/or swipe input device, a display, speakers, etc. The aforementioned devices are examples and others may be used.

The term computer-readable media as used herein may include non-transitory computer storage media. Computer storage media may include volatile and nonvolatile, removable and non-removable media implemented in any method or technology for storage of information, such as computer readable instructions, data structures, or program modules.

The system memory 720, the removable storage 760, and the non-removable storage 770 are all computer storage media examples (e.g., memory storage). Computer storage media may include RAM, ROM, electrically erasable read-only memory (EEPROM), flash memory or other memory technology, CD-ROM, digital versatile disks (DVD) or other optical storage, magnetic cassettes, magnetic tape, magnetic disk storage or other magnetic storage devices, or any other article of manufacture which can be used to store information and which can be accessed by the computing device 700. Any such computer storage media may be part of the computing device 700. Computer storage media may be tangible and non-transitory and does not include a carrier wave or other propagated or modulated data signal.

Communication media may be embodied by computer readable instructions, data structures, program modules, or other data in a modulated data signal, such as a carrier wave or other transport mechanism, and includes any information delivery media. The term "modulated data signal" may describe a signal that has one or more characteristics set or changed in such a manner as to encode information in the signal. By way of example, and not limitation, communication media may include wired media such as a wired network or direct-wired connection, and wireless media such as acoustic, radio frequency (RF), infrared, and other wireless media.

The terminology used herein is for the purpose of describing particular examples only and is not intended to be limiting of the inventive concept. Also, unless explicitly stated, the embodiments described herein are not mutually exclusive. Aspects of the embodiments described herein may be combined in some implementations.

As used herein, the singular forms "a" and "an" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing examples of the inventive concept refers to "one or more embodiments of the present disclosure." Also, the term "exemplary" is intended to refer to an example or illustration. As used herein, the terms "use," "using," and "used" may be considered synonymous with the terms "utilize," "utilizing," and "utilized," respectively.

Although exemplary embodiments of systems and methods for adjusting a target SOC based on an estimated gradient and a confidence factor have been specifically described and illustrated herein, many modifications and variations will be apparent to those skilled in the art. Accordingly, it is to be understood that the systems and methods for adjusting a target SOC based on an estimated gradient and a confidence factor constructed according to principles of this disclosure may be embodied other than as specifically described herein. The disclosure is also defined in the following claims, and equivalents thereof.

## Claims

1. A method, comprising:
determining a value of a radius r representing a distance at which a vehicle is estimated to have consumed a predetermined quantity of energy;
determining whether there are one or more descents that satisfy a criterion and begin within a circle having the radius r and centered at a location of the vehicle;
in accordance with a determination that there are one or more descents that satisfy the criterion and begin within the circle:
identifying one or more possible paths that each start at the location of the vehicle and include a descent of the one or more descents,
identifying a worst-case predicted total energy consumption for the one or more possible paths,
determining a target state of charge (SOC) based on the worst-case predicted total energy consumption,
determining a confidence value for the determined target SOC,
determining an adjusted target SOC based on the determined target SOC and the confidence value, and
causing a battery of the vehicle to be charged to the adjusted target SOC.

2. The method of any of the above claims, wherein the value of the radius r is determined based at least in part on an energy consumption characteristic of the vehicle, an altitude of the vehicle, or both.

3. The method of any of the above claims, wherein determining whether there are one or more descents that satisfy the criterion and begin within the circle comprises calculating one or more altitude changes between one or more pairs of topographic nodes, wherein each topographic node represents a geographic location and an altitude.

4. The method of any of the above claims, further comprising:
obtaining a set of topographic nodes comprising the one or more pairs of topographic nodes; and
selecting the one or more pairs of topographic nodes from the set of topographic nodes based at least in part on a location of the vehicle.

5. The method of any of the above claims, wherein determining whether there are one or more descents that satisfy the criterion and begin within the circle comprises estimating one or more gradient profiles based on a location of the vehicle, an altitude of the vehicle, a road map, or a combination of these.

6. The method of any of the above claims, wherein the criterion is satisfied when a grade of at least a portion of a descent exceeds a first threshold grade, when the distance of the descent exceeds a first threshold distance, when an average grade over a second threshold distance exceeds a second threshold grade, or a combination of these.

7. The method of any of the above claims, wherein identifying the one or more possible paths that each start at the location of the vehicle and include a descent of the one or more descents includes identifying one or more sets of topographic nodes including a starting node that is closest to the location of the vehicle and one or more ending nodes corresponding to the end of the one or more descents.

8. The method of any of the above claims, wherein identifying the worst-case predicted total energy consumption for the one or more possible paths comprises predicting an energy consumption for each possible path of the one or more possible paths by:
identifying one or more sets of topographic nodes corresponding to the one or more possible paths;
calculating altitude changes between pairs of topographic nodes of each set of topographic nodes; and
estimating a total energy consumption for each set of topographic nodes based on the calculated altitude changes and on energy consumption characteristics of the vehicle.

9. The method of any of the above claims, wherein identifying the worst-case predicted total energy consumption for the one or more possible paths comprises:
predicting the total energy consumption for each possible path of the one or more possible paths based on topographic mapping data; and
selecting a lowest predicted total energy consumption as the worst-case predicted total energy consumption.

10. The method of any of the above claims, further comprising:
in accordance with a determination that there are no descents that satisfy the criterion and begin within the circle, causing the battery of the vehicle to be charged to a maximum SOC.

11. A computing device for a vehicle, comprising:
at least one processor; and
a memory, operatively connected to the at least one processor and storing instructions that, when executed individually or collectively by the at least one processor cause the computing device to perform a method, the method comprising:
determining a value of a radius r representing a distance at which a vehicle is estimated to have consumed a predetermined quantity of energy;
determining whether there are one or more descents that satisfy a criterion and begin within a circle having the radius r and centered at a location of the vehicle;
in accordance with a determination that there are one or more descents that satisfy the criterion and begin within the circle:
identifying one or more possible paths that each start at the location of the vehicle and include a descent of the one or more descents,
identifying a worst-case predicted total energy consumption for the one or more possible paths,
determining a target state of charge (SOC) based on the worst-case predicted total energy consumption, and
causing a battery of the vehicle to be charged to the target SOC.

12. The computing device of claim 11, wherein the value of the radius r is determined based at least in part on an energy consumption characteristic of the vehicle, an altitude of the vehicle, or both.

13. The computing device of any of claims 11 and 12, wherein determining whether there are one or more descents that satisfy the criterion and begin within the circle comprises calculating one or more altitude changes between one or more pairs of topographic nodes, wherein each topographic node comprises a geographic location and an altitude.

14. The computing device of claim 13, wherein the method further comprises:
obtaining a set of topographic nodes comprising the one or more pairs of topographic nodes; and
selecting the one or more pairs of topographic nodes from the set of topographic nodes based at least in part on a location of the vehicle.

15. The computing device of any of claims 11 through 14, wherein identifying the worst-case predicted total energy consumption for the one or more possible paths comprises predicting the energy consumption for each possible path of the one or more possible paths by:
identifying one or more sets of topographic nodes corresponding to the one or more possible paths;
calculating altitude changes between pairs of topographic nodes of each set of topographic nodes; and
estimating the total energy consumption for each set of topographic nodes based on the corresponding altitude changes and on energy consumption characteristics of the vehicle.
